# EUROPÄISCHE PATENTSCHRIFT

(11) **EP 4 070 388 B1**
(45) Veröffentlichungstag und Bekanntmachung des Hinweises auf die Patenterteilung: **04.02.2026**
(21) Anmeldenummer: 20839222.5
(22) Anmeldetag: 04.12.2020
(51) Int. Cl.: H10N 10/13, E04D 13/00, F24S 20/67

(54) **SCHICHTAUFBAU ZUR ERZEUGUNG VON ELEKTRISCHER ENERGIE, VERFAHREN, GEBÄUDESTRUKTUR UND ENERGIEERZEUGUNGSANLAGE**
LAYER CONSTRUCTION FOR GENERATING ELECTRICAL ENERGY, METHOD, BUILDING STRUCTURE AND ENERGY GENERATION SYSTEM
STRUCTURE STRATIFIÉE POUR LA PRODUCTION D'ÉNERGIE ÉLECTRIQUE, PROCÉDÉ, STRUCTURE DE BÂTIMENT ET INSTALLATION DE PRODUCTION D'ÉNERGIE

(30) Priorität: 04.12.2019 DE 102019008407
(43) Veröffentlichungstag der Anmeldung: 12.10.2022
(73) Patentinhaber: Hochschule für Technik und Wirtschaft Berlin, 10318 Berlin (DE)
(72) Erfinder: GRÄF, Thomas, 12459 Berlin (DE)
(74) Vertreter: Verscht, Thomas Kurt Albert
(86) Internationale Anmeldenummer: PCT/DE2020/101028
(87) Internationale Veröffentlichungsnummer: WO 2021/110219

(56) Entgegenhaltungen:
- EP-A1- 2 239 787
- WO-A2-2009/030236
- DE-A1- 102009 022 745
- DE-A1- 102011 051 507
- DE-A1- 19 946 806
- MANEEWAN S ET AL: "Experimental investigation on generated power of thermoelectric roof solar collector", THERMOELECTRICS, 2003 TWENTY-SECOND INTERNATIONAL CONFERENCE ON - ICT LA GRANDE MOTTE, FRANCE AUG. 17-21, 2003, PISCATAWAY, NJ, USA,IEEE, 17 August 2003 (2003-08-17), pages 574 - 577, XP010697379, ISBN: 978-0-7803-8301-2

## Beschreibung

Die Erfindung betrifft einen Schichtaufbau zur Erzeugung von elektrischer Energie, ein Verfahren zur Erzeugung von elektrischer Energie, und ein Gebäudestruktur. Ferner betrifft die Erfindung eine Energieerzeugungsanlage mit einem Schichtaufbau.

Es sind Systeme zur Nutzung von Sonneneinstrahlung zur Erzeugung von elektrischer Energie bekannt. Solche Systeme sind beispielsweise Photovoltaikanlagen und Solarthermieanlagen. Ein Nachteil solcher Systeme ist ihr aufwendiger Aufbau. Ferner wird bei Solarthermieanlagen Wasser als Trägermedium verwendet, um aus Wärmeenergie elektrische Energie zu gewinnen. Es findet daher keine direkte Umwandlung von Wärmeenergie in elektrische Energie statt, sondern nur indirekt über das Medium Wasser.

WO2009/030236 A2 beschreibt eine Schichtstruktur zum Erzeugen elektrischer Energie aus der Temperaturdifferenz eines ersten Temperaturbereichs und eines zweiten Temperaturbereichs.

DE102011051507 A1 beschreibt eine Solarvorrichtung mit einem Solarelement, das zum Umwandeln von Solarenergie in elektrische und/oder thermische Energie ausgebildet ist.

Es ist von Nachteil, dass die bisherigen Konstruktionen zur Verwendung von Wärmestrahlung für die Erzeugung elektrischer Energie aufwendig aufgebaut sind.

Es stellt sich daher die Aufgabe, eine einfache und kompakte Bauweise zur Erzeugung von elektrischer Energie unter Verwendung von Wärmestrahlung anzugeben.

Die Erfindung löst diese Aufgabe mit einem Schichtaufbau zur Erzeugung von elektrischer Energie gemäß Anspruch 1.

Hierbei weist der Schichtaufbau eine wärmeleitfähige Schicht mit einer ersten Seite und einer zweiten Seite auf, wobei durch die wärmeleitfähige Schicht hindurch ein Wärmefluss übertragbar ist. Ferner ist der übertragene Wärmefluss einem Thermogenerator oder Thermoelement (Seebeck-Effekt) zuführbar, mit dem elektrische Energie erzeugbar ist. Ferner ist vorgesehen, dass zwischen der ersten Seite der wärmeleitfähigen Schicht und dem Thermogenerator eine Kopplungsschicht angeordnet ist.

Die vorliegende Erfindung basiert auf einer direkten Umwandlung von Wärmeenergie in elektrische Energie unter Verwendung von einem Thermogenerator. Ein Thermogenerator, auch thermoelektrischer Generator genannt, nutzt den physikalischen Seebeck-Effekt, um aus einer Temperaturdifferenz eine elektrische Spannung zu erzeugen. Es ist somit eine Temperaturdifferenz am Thermogenerator notwendig. Diese Temperaturdifferenz wird im vorliegenden Fall durch die Zuführung eines Wärmeflusses an den Thermogenerator erzeugt.

Unter Wärmefluss wird die thermische Energie, die von einem Ort zu einem anderen Ort fließt verstanden und kann durch die Wärmeleitgleichung von Fourier beschrieben werden. Temperaturdifferenzen führen zu einem Wärmetransport und damit zu einer Übertragung von Energie. Durchdringt Wärmeenergie einen Thermogenerator oder Thermoelemente, so kann mit dessen Hilfe Energie erzeugt werden. Der Wärmefluss wird beispielsweise unter Verwendung von solar eingestrahlter Wärmeenergie hervorgerufen. Die Quelle der Wärmeenergie ist beliebig. Es kann auch Abwärme verwendet werden, beispielsweise von Verbrennungsmotoren.

Der Schichtaufbau erzeugt elektrische Energie, sobald ein Wärmefluss den Thermogenerator erreicht. Der Thermogenerator wird in den Wärmefluss angeordnet. Da der Thermogenerator direkt an der wärmeleitfähigen Schicht über eine Kopplungsschicht angekoppelt ist, entstehen keine Behinderung des Wärmeflusses. Es wird mit Vorteil vorgesehen, dass der Thermogenerator direkt an der wärmeleitfähigen Schicht über eine Kopplungsschicht angekoppelt ist. Es entsteht keine Behinderung oder Blockierung des Wärmeflusses. Es werden Luftschichten oder gasförmige Räume zwischen der wärmeleitenden Schicht und dem Thermogenerator vermieden. Auf diese Weise wird der Wärmefluss ausschließlich durch Feststoffmaterial innerhalb der Schichtstruktur geleitet, um dem Thermogenerator zugeführt zu werden.

Die vorgesehene Kopplungsschicht sorgt für eine Ankopplung des Thermogenerators an die wärmeleitende Schicht, so dass möglichst die gesamte aufgenommene Wärme der wärmeleitenden Schicht in dem Thermogenerator zur Erzeugung von elektrischer Energie verwendet werden kann. Dies steigert den Wirkungsgrad der elektrischen Energieerzeugung. Die Kopplungsschicht ist im bestimmungsgemäßen Gebrauch eine Festschicht. Sie kann beispielsweise als Folienschicht und/oder Klebeschicht oder als ebenes Material, z.B. als Platte ausgebildet sein. Die Klebeschicht kann durch einen wärmeleitfähigen Spezialkleber hergestellt werden. Beispielsweise wird der Spezialkleber auf einer Seite des Thermogenerators aufgetragen wird, um diesen an der wärmeleitfähigen Schicht zu befestigen. Die Kopplungsschicht hat aufgrund ihres Materials wärmeleitfähige Eigenschaften und ist vollständig oder mindestens in Teilbereichen wärmeleitfähig. Sie verbessert die Wärmekopplung zwischen der wärmeleitfähigen Schicht und dem Thermogenerator. Die Kopplungsschicht übernimmt somit die Funktion, einen Wärmefluss dem Thermogenerator zuzuführen. Die Kopplungsschicht kann in bevorzugter Ausführungsform eine hochwärmeleitende Folie sein. Ferner kann die Folie als Trägerfolie verwendet werden.

Der vorgeschlagene Schichtaufbau ermöglicht eine einfache und kompakte Bauweise zum Erzeugen elektrischer Energie. Aufgrund dieser kompakten Bauweise kann der Schichtaufbau auch mit weiteren Technologien zur Wärmeerzeugung kombiniert werden, wie beispielsweise mit einer Photovoltaikanlage oder einer Solarthermieanlage. Die Kombination der vorliegenden Erfindung mit bisher bekannten Anlagentechnologien kann den Wirkungsgrad zur elektrischen Energiegewinnung weiter steigern.

In einem Ausführungsbeispiel kann vorgesehen sein, dass der Schichtaufbau mindestens eine strukturaufweisende Oberfläche aufweist.

Eine strukturaufweisende Oberfläche kann beispielsweise in Form von Kühlrippen gebildet werden. Ferner sind weitere Strukturen möglich, die die Oberfläche vergrößern, wie beispielsweise Strukturen einer Haifischhaut. Die strukturaufweisende Oberfläche verbessert die Wärmeabfuhr und sorgt für erhöhte Temperaturdifferenzen. Es kann beispielsweise vorgesehen werden, dass an dem Thermogenerator eine solche strukturaufweisende Oberfläche vorhanden ist, vorzugsweise an der Seite des Thermogenerators, die der Kopplungsschicht abgewandt ist. Mit Hilfe der strukturaufweisenden Oberfläche wird der Wärmefluss verbessert.

Ferner kann mit Vorteil in einer Ausführungsform des Schichtaufbaus eine Wärmeleitgeometrie vorgesehen sein. Eine solche Geometrie kann die Wärme flächig auf vorbestimmten Wegen leiten. Daher wird die Wärmeleitgeometrie in unmittelbarer Umgebung der Kopplungsschicht angeordnet. Auch kann die Kopplungsschicht selbst eine solche Wärmeleitgeometrie aufweisen. Die Wärmeleitgeometrie weist Bereiche auf, die sehr gut den Wärmefluss leiten und weist andere Bereiche auf, die den Wärmefluss weniger oder nicht leiten. Auf diese Weise kann der Wärmefluss gezielt durch den Schichtaufbau geleitete werden. Diese gezielte Leitung des Wärmeflusses kann in Richtung des Wärmeflusses, beispielsweise innerhalb der wärmeleitenden Schicht geschehen. Alternativ oder zusätzlich hierzu kann der Wärmefluss innerhalb der Kopplungsschicht oder einer benachbarten Schicht an der Kopplungsschicht gleitet werden. Es werden somit Bereiche unterschiedlicher Wärmeleitfähigkeiten eingesetzt, um den Wärmefluss innerhalb des Schichtaufbaus gezielt zu steuern. Die Wärmeleitfähigkeit beschreibt die Eigenschaft eines Materials und gibt an, wie gut die Wärme durch einen Körper geleitet wird. Je größer der Wert der Wärmeleitfähigkeit ist, desto mehr Wärme wird weitergeleitet. So sind Metalle gute Wärmeleiter und Kork ist ein geringer Wärmeleiter.

Ein Material, das für die Herstellung einer Wärmeleitgeometrie verwendet werden kann, um Wärme umleiten, ist beispielsweise Kork oder Styropor. Diese Materialien haben den Vorteil, dass sie gut zu verarbeiten sind und gleichzeitig mechanisch dämpfend wirken. Eine Wärmeleitgeometrie kann beispielsweise als eine zusätzliche Schicht zwischen der wärmeleitfähigen Schicht und der Kopplungsschicht verwendet werden, um den Wärmefluss aus der wärmeleitfähigen Schicht gezielt auszuführen bzw. dorthin einzuleiten. Es findet demnach eine flächige Umleitung der Wärme mit Hilfe der Schicht der Wärmeleitgeometrie statt. Es soll mit der Wärmeleitgeometrie erreicht werden, dass die eingedrungene Wärme in der wärmeleitfähigen Schicht möglichst vollständig an den Thermogenerator über die Kopplungsschicht abgebeben wird. Über eine gewählte vordefinierte Geometrie der Wärmeleitgeometrie gelingt es, dass möglichst viel Wärmeenergie den Thermogenerator erreicht. Auf diese Weise wird die Temperaturdifferenz am Thermogenerator erhöht und die Energiegewinnung verbessert.

Ferner wird in einem bevorzugten Ausführungsbeispiel des Schichtaufbaus vorgesehen, dass der Thermogenerator in zwei Richtungen des Wärmeflusses betreibbar ist. Es liegen dann im Vergleich zum Seebeck-Effekt umgekehrte Verhältnisse vor, die technisch basierend auf dem Peltier-Effekt genutzt werden. Auch bei diesem Anwendungsfall ist eine Temperaturdifferenz am Thermogenerator vorhanden, der technisch genutzt wird. Das Betreiben des Thermogenerators bei unterschiedlichen Richtungen des Wärmeflusses kann durch eine Polumschaltung am Thermogenerator durchgeführt werden. Hierzu werden beispielsweise eine elektrische Schaltung und eine Sensoranordnung verwendet, um eine Umkehrung des Wärmeflusses zu erkennen und nach Erkennung eine Polumschaltung durchzuführen. Durch eine Polumschaltung am Thermogenerator kann mit diesem weiterhin elektrische Energie gewonnen werden.

Wird beispielsweise der Schichtaufbau in einer Dachkonstruktion eines Gebäudes installiert, so wird bei einer höheren Temperatur im Außenbereich im Vergleich zu einer Temperatur im Innenbereich ein Wärmefluss von außen nach innen bewirkt. In dieser ersten Richtung des Wärmeflusses arbeitet der Thermogenerator ohne Polumkehr und erzeugt eine Gleichspannung. Erreicht die Innentemperatur im Gebäude einen höheren Wert als die Außentemperatur außerhalb des Gebäudes, so fließt die Wärme von innen nach außen und der Wärmefluss kehrt sich um. Bei dieser zweiten Richtung des Wärmeflusses ist es von Vorteil, den Thermogenerator ebenfalls zur Energiegewinnung betreiben zu können. Da sich jedoch die Gleichspannung am Thermogenerator in dieser Situation umpolt, ist es von Vorteil eine Spannungsumkehrung am Thermogenerator vorzusehen. Auf diese Weise kann die gewonnene Energie ohne zusätzliche Maßnahmen weiterhin verwendet oder gespeichert werden. Dies ist mit Einrichtungen zum Einleiten einer Polumkehrung möglich, so dass der Thermogenerator in zwei Richtungen des Wärmeflusses betreibbar ist. Hierbei wird der Wirkungsgrad der Energiegewinnung gesteigert, da die Energiegewinnung beispielsweise auch nachts betrieben wird, während andere Anlagen (Photovoltaik oder Solarthermieanlagen) aufgrund von fehlender solarer Wärmestrahlung keine elektrische oder thermische Energie erzeugen können. Bei der vorliegenden Erfindung und ihren Ausführungsbeispielen genügt lediglich eine Temperaturdifferenz am Thermogenerator, unabhängig von solarer Wärmeeinstrahlung.

In einem bevorzugten Ausführungsbeispiel kann vorgesehen werden, dass der Schichtaufbau eine Vielzahl von Thermogeneratoren aufweist, die elektrisch miteinander verbunden ist. Hierbei werden die Thermogeneratoren zu einem elektrischen Netzwerk zusammengeschaltet. Das Netzwerk der Thermogeneratoren kann durch eine Reihenschaltung, eine Parallelschaltung oder eine Kombination gebildet werden. Ferner kann eine elektronische Schaltung zur Aufbereitung bzw. Anpassung der Spannungs- und/oder Stromwerte vorgesehen werden für die weitere Energieverwertung. Eine Zusammenschaltung von mehreren Thermogeneratoren hat den Vorteil, dass aufgrund einer flächigen wärmeleitfähigen Schicht an unterschiedlichen Stellen Energie erzeugt wird, die dann zusammengeführt werden kann, um beispielsweise einen Verbraucher zu speisen. Die aus dem Thermogenerator erzeugte Spannung (Nutzspannung) kann unter Verwendung einer elektronischen Anpassschaltung auf standardisierte Spannungswerte, z.B. 60 V (Kleinspannung) oder 230 V als Gleich- oder Wechselspannung oder eine Mischform hiervon angepasst werden.

Erfindungsgemäß weist der Schichtaufbau eine Schutzvorrichtung auf. Dies ist besonders von Vorteil, wenn der Schichtaufbau der Umwelt ausgesetzt ist. Mögliche Umwelteinflüsse sind Blitze sowie Feuchte in Form von Regen, Schnee, Betauung.

Vorzugsweise wird der Thermogenerator auf der Seite der wärmeleitenden Schicht angeordnet, die Umwelteinflüssen vermindert ausgesetzt ist. Der Thermogenerator ist beispielsweise hinter bzw. an der Fassade eines Gebäudes installiert, während die wärmeleitfähige Schicht auf ihrer dem Thermogenerator abgewandten Seite die Fassade des Gebäudes bildet. Dennoch können auch in solchen geschützten Bereichen indirekt Umweltweinflüsse vorhanden sein, beispielsweise Betauung durch vorhandene Temperaturwechsel. Somit ist vorzugsweise eine Schutzvorrichtung gegen Feuchte vorzusehen. Hierzu kann der Thermogenerator durch eine wasserdichte Schutzschicht oder eine Kapselung geschützt werden. Diese Schutzschicht ist vorzugsweise wärmeleitfähig, damit der Wärmestrom am Thermogenerator nicht durch die überdeckende Schutzschicht beeinflusst wird. Als ein Ausführungsbeispiel kann zum Schutz gegen Feuchtigkeit z.B. eine Beschichtung des gesamten Schichtaufbaus vorgesehen werden, beispielsweise an einer Ziegelinnenseite, falls die wärmeleitfähige Schicht durch einen oder mehrere Ziegel gebildet wird.

Erfindungsgemäß schützt eine Schutzvorrichtung den Schichtaufbau vor elektrischen Einflüssen.

Es kann eine elektrische Schutzbeschaltung verwendet werden. Hierbei wird der Schichtaufbau, insbesondere der Thermogenerator und weitere elektrische Schaltungen, vor Überspannungen und elektromagnetischen Einkopplungen geschützt.

In einem weiteren Ausführungsbeispiel kann vorgesehen werden, dass der Schichtaufbau mindestens eine Telekommunikationseinrichtung aufweist.

Mit einer Telekommunikationseinrichtung, beispielsweise zum Bereitstellen einer Funkverbindung können Messungen an dem Schichtaufbau gesammelt und ortsunabhängig analysiert werden. Als Funkverbindungen eigenen sich Verbindungen im Nahbereich, wie Bluetooth oder WLAN und im Fernbereich das Mobilfunknetz. Ferner können In-Line-Kommunikationseinrichtungen verwendet werden, d.h. aufmodulierte Signale in einer elektrischen Stromleitung. Auch kommen Glasfaserverbindungen in Frage. Mit einer solchen bereitgestellten Telekommunikationsverbindungen, drahtgebunden, drahtlos oder fasergebunden können Messergebnisse, Analysedaten, Diagnosedaten von Sensoren bereitgestellt werden. Hierzu wird der Schichtaufbau mit mindestens einem Sensor ausgestattet, der Messergebnisse, wie Temperaturverläufe, gewonnene elektrische Energie und/oder Strahlungsintensität aufnehmen kann und an die Telekommunikationsverbindung zur Weiterverarbeitung leiten kann.

In einem weiteren Ausführungsbeispiel kann vorgesehen werden, dass die Schutzvorrichtung als Umhüllung ausgebildet ist, insbesondere als eine elektromagnetisch-abgedichtete Kapselung.

Eine elektromagnetisch-abgedichtete Kapselung kann als Schutzvorrichtung des Schichtaufbaus verstanden werden. Eine solche Schutzvorrichtung kann in Form einer Kapselung oder eines Gehäuses ausgebildet sein. Die Schutzvorrichtung kann ein EMV-dichtes (EMV = elektromagnetische Verträglichkeit) Gehäuse sein. Insbesondere kann die Schutzvorrichtung den gesamten Schichtaufbau und/oder den Thermogenerator aufnehmen und gegen elektrische und magnetische Felder abschirmen. Eine metallische Umhüllung kann aus Aluminiummaterial oder Kupfermaterial gebildet sein.

Erfindungsgemäß ist die Schutzvorrichtung des Schichtaufbaus eine Schutzschaltung.

Die Schutzvorrichtung kann eine Schutzschaltung sein, die vor der Wirkung von elektrischen und magnetischen Feldern schützt. Die Schutzschaltung ist dazu geeignet, den gesamten Schichtaufbau vor Überspannungen zu schützen, insbesondere vor Wirkungen von außen, beispielsweise in Form eines Blitzimpulses, der sich in Form von Überspannungen auswirkt.

Auch können indirekte Überspannungen mit der Schutzvorrichtung verhindert bzw. zumindest reduziert werden. Solche indirekten Überspannungen können durch Induktion entstehen. Beispielsweise können Induktionsspannungen in einer Dachkonstruktion durch einen Blitzeinschlag hervorgerufen werden. Die Schutzvorrichtung kann eine elektrische Schutzschaltung aufweisen, beispielsweise eine Elektronik mit einem Überspannungsschutz, wie einem Ableiter oder Schalter, beispielsweise in Form eines Halbleiters.

Es ist vorteilhaft, dass eine Schutzschaltung auch nachgeschaltete Elektronik schützen kann, d.h. Elektronik, die dem Thermogenerator nachgeschaltet ist, um beispielsweise eine Spannung in ihrer Höhe zu wandeln oder ein Signal zu wandeln. Besonders empfindlich gegenüber Überspannungen ist eine Wandlerelektronik zum Wandeln der erzeugten elektrischen Spannungen des Thermogenerators. Es wird mit der Wandlerelektronik beispielsweise eine Kleinspannung in eine Versorgungsspannung gewandelt.

Insgesamt kann mit der Schutzvorrichtung eine nachgeschaltete Elektronik, insbesondere eine Wandlerelektronik zum Wandeln der erzeugten Spannungen eines Thermogenerators vor Überspannungen geschützt werden. Ferner können mit der Schutzschaltung weitere Bauteile vor Überspannungen geschützt werden, wie installierte Sensoren an dem Schichtaufbau.

In einer weiteren vorteilhaften Ausführungsform kann ein Schichtaufbau 11, beispielsweise an einem Ziegel oder an einer Vielzahl von Ziegeln mit einer Auswertevorrichtung 44 verbunden werden, die eine Recheneinrichtung 45 aufweist. Mit der Auswertevorrichtung 44 können Messwerte einer Energieerzeugungsanlage mit dem installierten Schichtaufbau ausgewertet werden und Parameter der Energieerzeugungsanlage, wie Einspeisegrad und Wirkungsgrad berechnet werden. Hierbei können auch zusätzlich zu den Messwerten weitere Daten der Energieerzeugungsanlage berücksichtigt werden, wie bereitgestellte Einstrahlfläche oder Gesamtzahl der installierten Ziegel. Als Auswertevorrichtung 44 kann auch als eine Überwachungsvorrichtung verstanden werden. Diese Überwachungsvorrichtung kann lokal an der Anlage installiert sein oder auch in Form einer Fernwarte vorhanden sein. Eine Fernwarte kann eine zentrale Leitstelle eines Energienetzes sein.

In einem weiteren Ausführungsbeispiel kann vorgesehen werden, dass die Schutzvorrichtung einen oder eine Vielzahl von Sensoren aufweist.

Installierte Sensoren an dem Schichtaufbau bzw. an einer Gebäude- oder Fahrzeugstruktur haben viele Vorteile. Sensoren können elektrische, magnetische optische, akustische oder ähnliche Parameter des Schichtaufbaus erfassen. Ferner können mit Sensoren Umwelteinflüsse erfasst werden, wie beispielsweise Lichteinfall, Feuchte und/oder Temperatur. Auch können Sensoren verwendet werden, um die Betriebsführung der Energieerzeugungsanlage zu unterstützen, die einen erfindungsgemäßen Schichtaufbau aufweist. Sensoren zur Betriebsführung können beispielsweise Strom- und Spannungsmessungen durchführen oder Überspannungen feststellen. In Falle von überhöhten Werten der gemessenen Kenngrößen können Maßnahmen an der Energieerzeugungsanlage eingeleitet werden, wie beispielsweise Abschaltung, mechanisches Abdecken von sensiblen Anlagenteilen, z.B. als Schutz vor Hagelschäden oder bei hohen Windlasten an Teilen der Energieerzeugungsanlage. Mit Vorteil können Sensoren verwendet werden, z.B. Drucksensoren zur Messung mechanischer Belastungen, z.B. von Winddruck an einer Dachkonstruktion, und/oder Sensoren zur Aufnahme von Wetterdaten, wie atmosphärischer Druck, um Gefahren einschätzen zu können und Maßnahmen zu ergreifen.

In einem weiteren Ausführungsbeispiel kann vorgesehen werden, dass der Schichtaufbau eine Wärmetransport-hindernde Geometrie aufweist.

Eine Wärmetransport-hindernde Geometrie kann flächig als Schicht ausgebildet sein. Auch kann eine Wärmetransport-hindernde Geometrie dreidimensional ausgebildet sein. Die Wärmetransport-hindernde Geometrie kann mit einer Wärmeleitgeometrie kombiniert werden. Eine solche Geometrie verhindert, dass ein Wärmetransport an eine bestimmte Stelle oder einen bestimmten Bereich des Schichtaufbaus gelangt. Eine solche Wärmetransport-hindernde kann den Wirkungsgrad der Gesamtanordnung erhöhen. Dies kann geschehen, indem der Wärmefluss über eine vorbestimmte Stelle oder vorbestimmten Bereich blockiert wird und über eine andere vorbestimmte Stelle oder einen vorbestimmten Bereich gezielt geführt wird, und hierbei die Konvektions- und Strahlungsverluste reduziert werden. Es ist auch möglich, die Wärmetransport-hindernde Geometrie mit einer Wärmeleitgeometrie zu kombinieren. Auf diese Weise entstehen dreidimensionale Schichten oder zweidimensionale Bereiche mit vordefinierten Eigenschaften in Bezug auf die Wärmeleitfähigkeit.

In einem weiteren Ausführungsbeispiel kann vorgesehen werden, dass der Schichtaufbau einen faseroptischen Sensor oder eine Vielzahl von faseroptischer Sensoren aufweist.

Es können faseroptische Sensoren so angeordnet sein, dass eine Temperaturmessung an einem einzelnen Schichtaufbau oder einer Struktur gebildet mit einem Schichtaufbau gemäß einer Ausführungsform der vorliegenden Erfindung möglich ist. Demnach kann eine Temperaturmessung einem einzelnen Ziegel oder an einem Verbund von Ziegeln oder an jedem Ziegel und im Verbund vorgesehen werden. Es ist eine Temperaturmessung, insbesondere eine verteilte Temperaturmessung möglich. Eine solche Temperaturmessung erlaubt die Wirkungsgradbestimmung der Anlage. Ferner ermöglicht eine solche Temperaturmessung eine Überwachung und Diagnose der Veränderung der Energiegewinnung durch Temperaturmonitoring. Ein Monitoring erlaubt eine zeitlich kontinuierliche Messung der Temperaturverteilung an dem Schichtaufbau bzw. an einer Struktur, die durch eine wärmeleitende Schicht gebildet wird, wie einem Gebäude oder einem Transportmittel. Durch eine Verteilung von Sensoren an der wärmeleitfähigen Schicht, beispielsweise in Form einer Gebäudestruktur, kann sowohl eine zeitlich kontinuierliche Überwachung wie auch eine geometrische Überwachung von sich verändernden Temperaturbereichen an der wärmeleitfähigen Schicht gemessen werden.

Ferner wird die Aufgabe der Erfindung mit einem Verfahren zur Erzeugung von elektrischer Energie gemäß Anspruch 11 gelöst.

Hierzu sieht das Verfahren ein Bereitstellen einer wärmeleitfähigen Schicht mit einer ersten Seite und einer zweiten Seite vor, wobei durch die wärmeleitfähige Schicht hindurch ein Wärmefluss übertragbar ist. Ferner wird ein Thermogenerator bereitgestellt. Das Verfahren sieht weiter ein Anordnen einer Kopplungsschicht zwischen der ersten Seite der wärmeleitfähigen Schicht und dem Thermogenerator vor und ein Zuführen des übertragenen Wärmeflusses an den Thermogenerator. Ferner sieht das Verfahren ein Erzeugen von elektrischer Energie mit dem Thermogenerator vor. Ferner sieht das Verfahren ein Bereitstellen einer Schutzvorrichtung, wobei die Schutzvorrichtung eine Schutzschaltung zum Schutz vor Überspannungen ist, vor.

Die erzeugte elektrische Energie kann einem oder mehreren Verbrauchern und/oder einem oder mehreren Energiespeichern zur Verfügung gestellt werden. Ferner kann das Verfahren ein Steuern des Thermogenerators, ein Einleiten einer Schutzmaßnahme und/oder ein Analysieren von Messdaten und/oder Sensordaten vorsehen. Hierzu werden eine Schutzschaltung und/oder mindestens ein Sensor bereitgestellt.

Ferner kann vorgesehen werden, dass der Energiespeicher oder eine Vielzahl von Energiespeichern am Schichtaufbau installiert ist. Es kann beispielsweise ein Energiespeicher direkt am Thermogenerator oder in seiner Umgebung angeordnet werden.

Ferner wird die Aufgabe der Erfindung mit einer Gebäudestruktur gelöst, die den erfindungsgemäßen Schichtaufbau aufweist.

Durch die kompakte und flache Bauweise des erfindungsgemäßen Schichtaufbaus können Gebäudestrukturen, wie Dächer, Fassaden und Balkonverkleidungen unabhängig von ihrer Geometrie und Ihres Neigungsgrades zur elektrischen Energiegewinnung genutzt werden. Der erfindungsgemäße Schichtaufbau kann in eine solche Gebäudestruktur integriert werden und beispielsweise eine Fassaden- oder Dachfläche bilden. Die Verwendung des erfindungsgemäßen Schichtaufbaus in oder an Gebäuden ist einfach möglich. Der Schichtaufbau kann beliebig in seiner Geometrie gewählt werden. So können nur wenige Quadratzentimeter bis zu mehreren hundert Quadratmeter Fläche genutzt werden. Auch kann der Schichtaufbau Krümmungen aufweisen, um sich einer vorgegebenen Geometrie anzupassen. Ferner kann bei einer Dachkonstruktion beispielsweise jeder Ziegel mit einem Thermogenerator ausgestattet sein, so dass hunderte von Thermogeneratoren durch elektrische Zusammenschaltung eine gemeinsame Energiequelle bilden.

In einem Ausführungsbeispiel kann vorgesehen werden, dass die Gebäudestruktur eine Vielzahl von Thermogeneratoren aufweist, die über eine Sammelanordnung miteinander verbunden ist. Ferner kann die Sammelanordnung mit einer Auswertevorrichtung verbunden sein. Auf diese Weise können alle Messdaten der Thermogeneratoren und weitere Messdaten der Anordnung in einer zentralen Einheit ausgewertet werden.

In einem Ausführungsbeispiel kann vorgesehen werden, dass die Gebäudestruktur eine erste Seite aufweist, die einer solaren Einstrahlung zugewandt ist und eine zweite Seite aufweist, die der solaren Einstrahlung abgewandt ist, wobei auf der ersten Seite ein Solarmodul angeordnet ist und wobei der Thermogenerator oder die Vielzahl von Thermogeneratoren auf der zweiten Seite angeordnet ist.

Es kann mit Vorteil eine Gebäudestruktur vorgesehen werden, bei der zwischen einer Ziegelanordnung mit mehreren Ziegeln und einer Unterkonstruktion eines Daches ein Abstand vorhanden ist. Dieser Abstand wird durch die Dachkonstruktion bestimmt und befindet sich zwischen der Dachunterkonstruktion und der Ziegelanordnung. Der Abstand sorgt für ausreichende Hinterlüfung der Dachkonstruktion bzw. Konvektion an dem Thermogenerator.

Der Thermogenerator kann direkt oder indirekt an der Ziegelschicht befestigt sein. Hierbei ist unter einem Ziegel ein Elemente zu verstehen, das eine Außenhaut einer Dachkonstruktion oder einer Gebäudekonstruktion bildet. Der Begriff ist auf keine spezielle Geometrie einer solchen Außenhaut begrenzt. Der Begriff Ziegel soll verdeutlichen, dass es sich um einen Bereich des Daches oder um einen Teil eines Daches handelt. Der Begriff Ziegel lässt sich auch durch z.B. Dachblech ersetzen. Die Funktionalität der Wärmeleitung und Energiegewinnung bleibt vollumfänglich erhalten.

Ferner kann von Vorteil sein, dass der Thermogenerator oder eine Vielzahl von Thermogeneratoren mit einer Photovoltaikanlage oder einer Solarthermieanlage kombiniert wird. Hierbei ist eine Kombination von einem Solarmodul mit einem oder mehreren Thermogeneratoren einfach zu installieren oder auch ein oder mehrere Solarmodule nachzurüsten. Hierbei können insbesondere Solarmodulen in Form von Ziegeln einer Dachkonstruktion auf einfache Weise nachgerüstet werden. Es ist eine Kombination aus Solarmodul pro Ziegel und Thermogenerator pro Ziegel möglich. Es können Solarziegel vorgesehen werden, die an ihrer Unterseite einen oder eine Vielzahl von Thermogeneratoren aufweisen. Eine solche Kombination von Solarmodul bzw. Solarziegel und einem oder mehrere Thermogeneratoren kann einen höheren Wirkungsgrad bzw. eine erhöhte Ausbeute der Energieerzeugungsanlage bei unveränderter Geometrie bewirken.

Es kann vorgesehen sein, dass ein Thermogenerator an der Unterseite eines Dachziegels angeordnet ist, wobei die Unterseite der solaren Einstrahlung abgewandt ist. Der Ziegel kann zugleich ein Solarziegel sein. Auf diese Weise ist es möglich, solare Sonnenenergie und Energie, thermisch gewonnen mit dem Thermogenerator, zeitgleich und in einer Dachkonstruktion, insbesondere an einem einzigen Dachziegel zu gewinnen. Die so ausgestatteten Dachziegel können als Energiesammeleinrichtung miteinander verschaltet werden, um mit zwei voneinander unabhängigen Energiequellen Energie zu gewinnen. Dies hat den Vorteil, wenn z.B. bei Dunkelheit keine solare Energie zur Verfügung steht, dennoch elektrische Energie gewonnen werden kann, nämlich durch Temperaturdifferenzen am Thermogenerator.

Ferner kann eine Energieerzeugungsanlage mit einem erfindungsgemäßen Schichtaufbau vorgesehen werden.

Eine Energieerzeugungsanlage kann beispielsweise eine Photovoltaikanlage oder eine Solarthermieanlage sowie eine Anlage mit einer Kombination der beiden Technologien sein. Solche Anlagen können bei Neuinstallation mit einem erfindungsgemäßen Schichtaufbau und Abwandlungen hiervon versehen werden. Ferner können auch bereits installierte Energieerzeugungsanlagen mit dem vorgeschlagenen Schichtaufbau versehen werden, d.h. nachgerüstet werden. Hierbei kann sich der Wirkungsgrad bei der Erzeugung von elektrischer und/oder thermischer Energie der vorhandenen Anlage weiter erhöhen. Durch die flache Struktur des Schichtaufbaus von wenigen Millimetern bis einigen Zentimeter Dicke ist eine Integration des Schichtaufbaus bei Neuanlagen wie auch bei Bestandsanlagen leicht möglich.

Die Erfindung, sowie weitere Merkmale, Ziele, Vorteile und Anwendungsmöglichkeiten derselben, wird bzw. werden nachfolgend anhand einer Beschreibung von bevorzugten Ausführungsbeispielen unter Bezugnahme auf die beigefügten Zeichnungen näher erläutert. In den Zeichnungen bezeichnen dieselben Bezugszeichen dieselben bzw. entsprechende Elemente. Dabei bilden alle beschriebenen und/oder bildlich dargestellten Merkmale für sich oder in beliebiger sinnvoller Kombination den Gegenstand der vorliegenden Erfindung, und zwar unabhängig von ihrer Zusammenfassung in den Patentansprüchen oder deren Rückbeziehung. In den Zeichnungen zeigen:
- Fig. 1: ein erstes Ausführungsbeispiel eines erfindungsgemäßen Schichtaufbaus;
- Fig. 2: ein Ausführungsbeispiel einer Wärmeleitgeometrie;
- Fig. 3: ein zweites Ausführungsbeispiel eines erfindungsgemäßen Schichtaufbaus;
- Fig. 4: einen Ausschnitt einer Gebäudestruktur, insbesondere einer Dachkonstruktion mit einem dritten Ausführungsbeispiel eines installierten erfindungsgemäßen Schichtaufbaus;
- Fig. 5: eine Trägerstruktur mit einem vierten Ausführungsbeispiel eines installierten erfindungsgemäßen Schichtaufbaus;
- Fig. 6: eine Trägerstruktur mit einem fünften Ausführungsbeispiel eines installierten erfindungsgemäßen Schichtaufbaus;
- Fig. 7: einen Ausschnitt einer Gebäudestruktur, insbesondere einer Dachkonstruktion mit einem sechsten Ausführungsbeispiel eines installierten erfindungsgemäßen Schichtaufbaus; und
- Fig. 8: ein Beispiel einer Zusammenschaltung einer Vielzahl von Thermogeneratoren am Beispiel einer Dachkonstruktion.

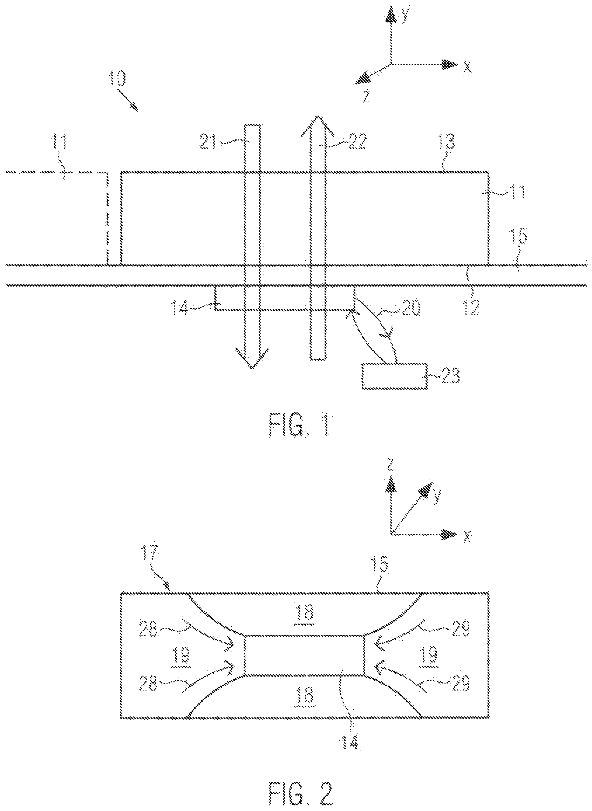

Fig. 1 zeigt ein erstes Ausführungsbeispiel eines erfindungsgemäßen Schichtaufbaus 10 zur Erzeugung von elektrischer Energie 20. Der Schichtaufbau 10 ist wird unabhängig von seiner Einbaulage beschrieben, die Bezeichnungen "horizontal", "vertikal", "oben" und "unten" beziehen sich lediglich auf die dargestellte Fig. 1. Der Schichtaufbau 10 der Fig. 1 weist drei übereinander liegende Schichten auf, die oberste Schicht ist eine wärmeleitfähige Schicht 11, die in vertikaler Richtung Wärme leitet, um Wärme von einer ersten Seite 11 an eine zweite Seite 12 zu leiten und umgekehrt. Der Wärmefluss durch die wärmeleitende Schicht 11 richtet sich nach einer Temperaturdifferenz, die zwischen der ersten Seite 12 und der zweiten Seite 13 vorhanden ist. Die erste Seite 12 ist beispielsweise eine Innenseite eines Gebäudes, Fahrzeug oder dergleichen. Die zweite Seite 13 ist beispielsweise eine Außenseite, die der Innenseite gegenüber liegt. Ist die Temperatur außen höher als innen, so ergibt sich ein erster Wärmefluss 21. Ist die Temperatur außen niedriger als innen, so ergibt sich ein zweiter Wärmefluss 22. In beiden Fällen kann der Wärmefluss 21, 22 genutzt werden, um elektrische Energie 20 an einem Thermogenerator 14 zu erzeugen. Die elektrische Energie 20 kann in einem Energiespeicher 23 gespeichert werden. Der Energiespeicher 23 kann entfernt von dem Schichtaufbau 10 aufgestellt sein und beispielsweise an mehrere Thermogeneratoren 14 und deren Beschaltung angeschlossen werden. Der Thermogenerator 14 ist möglichst nahe an der wärmeleitenden Schicht 11 angeordnet. Zwischen der wärmeleitenden Schicht 11 und dem Thermogenerator 14 ist lediglich eine Kopplungsschicht 15 angeordnet.

Es ergibt sich somit ein Schichtaufbau, gesehen von oben nach unten in Fig. 1: wärmeleitfähige Schicht 11, Kopplungsschicht 15 und Thermogenerator 14. Der gesamte Schichtaufbau 10 beträgt in vertikaler Richtung (y-Richtung) der Fig. 1, d.h. in seiner Höhe, wenige Millimeter bis wenige Zentimeter. In horizontaler Richtung (x-Richtung) hingegen ist der Schichtaufbau 10 nicht limitiert. Er ist skalierbar und kann dem Einsatzbereich angepasst werden. Somit ergeben sich wenige Quadratzentimeter bis einige hunderte Quadratmeter mögliche Fläche der wärmeleitenden Schicht 10 unter Berücksichtigung des horizontalen Ausmaßes (x-Richtung) und der dritten Dimension in Fig. 1, d.h. in die Ebene hinein bzw. heraus (z-Richtung). Es ist auch möglich, mehrere wärmeleitende Schichten 11 nebeneinander in x-Richtung anzuordnen, beispielsweise in Form von Ziegeln. Auf diese Weise kann ein modularer Aufbau erfolgen, wobei jedem Ziegel oder nur bestimmten Ziegeln jeweils ein Thermogenerator 14 zugeordnet werden kann. Die Kopplungsschicht 15 kann den Ziegeln gemeinsam zugeordnet werden, so dass eine gemeinsame Kopplungsschicht 15 für alle Ziegel vorhanden ist.

Die Kopplungsschicht 15 ist beispielsweise eine wärmeleitende Folie oder Trägerfolie, vorzugsweise ist sie eine hochwärmeleitende Folie oder Trägerfolie. Sie kann nur ein Bruchteil von Millimetern Dicke aufweisen oder mehrere Millimeter Dicke haben. Vorzugsweise hat die Kopplungsschicht 15 eine konstante Dicke über ihre gesamte Fläche. Die Kopplungsschicht 15 hat die Eigenschaft, die gesamte Wärme der wärmeleitenden Schicht 11 an den Thermogenerator 15 weiterzuleiten oder von diesem abzuführen in Abhängigkeit des Temperaturgefälles und somit des Wärmeflusses. Zur verbesserten Weiterleitung der Wärme an den Thermogenerator 14 können eine oder mehrere Wärmeleitgeometrien 17 verwendet werden. Diese sind beispielsweise Teil der wärmeleitenden Folie der Kopplungsschicht 15. Ferner ist es möglich hierzu eine weitere Schicht vorzusehen, die zwischen wärmeleitfähiger Schicht 11 und Kopplungsschicht 15 angeordnet ist. Die weitere Schicht kann auch zwischen Kopplungsschicht 15 und Thermogenerator 14 angeordnet werden. Bevorzugt ist eine einzige Schicht als Kopplungsschicht 15 mit einer integrierten Wärmeleitgeometrie 17, d.h. mit Bereichen hoher und geringer Wärmeleitfähigkeit in einer Ebene. Insgesamt ergibt sich durch die direkte Kontaktierung von wärmeleitfähiger Schicht 11, Kopplungsschicht 15 und Thermogenerator 14 ein kompakter und einfacher Aufbau. Durch die Vermeidung von Luftschichten zwischen den Schichten 11, 15, 14 wird die Wärmeleitfähigkeit der Materialien so genutzt, dass die Wärme am Thermogenerator 14 möglichst ungehindert ankommt und eine möglichst hohe Temperaturdifferenz am Thermogenerator 14 zur elektrischen Energieerzeugung verwendet werden kann.

Fig. 2 zeigt ein Ausführungsbeispiel einer Wärmeleitgeometrie 17 auf der Unterseite einer Kopplungsschicht 15, auf der ein Thermogenerator 14 befestigt ist, beispielsweise durch Kleben. Die Wärmeleitgeometrie 17 weist erste Bereiche 18 auf, die weniger gut wärmeleitfähig sind, d.h. mit geringem Wärmeleitwert 18 und zweite Bereiche 19, die sehr gut wärmeleitfähig sind, d.h. einen hohen Wärmeleitwert aufweisen bzw. eine höheren Wärmeleitwert aufweisen im Vergleich zu dem ersten Bereich 18. Auf diese Weise stellen sich flächige Wärmeflüsse 28, 29 ein, die dem Thermogenerator 14 zugeleitet werden. Die Wärmeflüsse 28, 29 fließen in x-z-Richtung der Fig. 2. Auf diese Weise kann der Thermogenerator 14 zusätzliche elektrische Energie aufgrund der zugeleiteten Wärmeflüsse 28, 29 erzeugen.

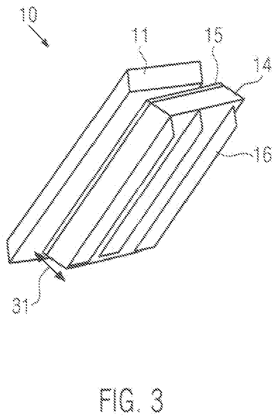

Fig. 3 zeigt ein zweites Ausführungsbeispiel eines erfindungsgemäßen Schichtaufbaus 10 in perspektivischer Ansicht. Der Schichtaufbau 10 weist eine wärmeleitfähige Schicht 11 und eine darunterliegende und direkt an die wärmeleitfähige Schicht 11 angrenzende Kopplungsschicht 15 auf. Die wärmeleitfähige Schicht 11 kann Teil einer Gebäudeaußenhaut sein, beispielsweise Teil einer Fassade oder einer Dachkonstruktion. Auf der Kopplungsschicht 15 ist ein Thermogenerator 14 angebracht, der mit einer strukturierten Oberfläche 16 in Form eines Kühlkörpers versehen ist. Der Kühlkörper weist in Längsrichtung zueinander parallel verlaufende Kühlrippen auf. Der Kühlkörper kann über eine zweite Kopplungsschicht mit dem Thermogenerator 14 verbunden sein. Hierbei kann die zweite Kopplungsschicht ebenso wie die erste Kopplungsschicht 15 als Folie, gehärteter Kleber oder sonstiger Feststoff ausgebildet sein, die ebenso wie die erste Kopplungsschicht 15 wärmeleitfähig ist.

Die Kühlrippen stellen eine strukturierte Oberfläche 16 dar und vergrößern die Oberfläche des Thermogenerators 14 auf der Seite, die der ersten Kopplungsschicht 15 abgewandt ist. Diese ist im bevorzugten Fall frei von weiteren Abdeckungen. Somit kann die Wärme an den Kühlrippen schneller und vermehrt entweichen als dies ohne Kühlrippen der Fall wäre. Ferner können Sensoren zur Messung der Temperatur verwendet werden, um beispielsweise den Wirkungsgrad des Schichtaufbaus 10 festzustellen. Hierbei können Sensoren außen am Dachziegel, am Thermogenerator wie auch in den Kopplungsschichten angeordnet werden. Ein Pfeil 31 deutet die Richtung des Temperaturgradienten bzw. eine Temperaturdifferenz zwischen zwei Orten an, die mit Sensoren gemessen werden kann.

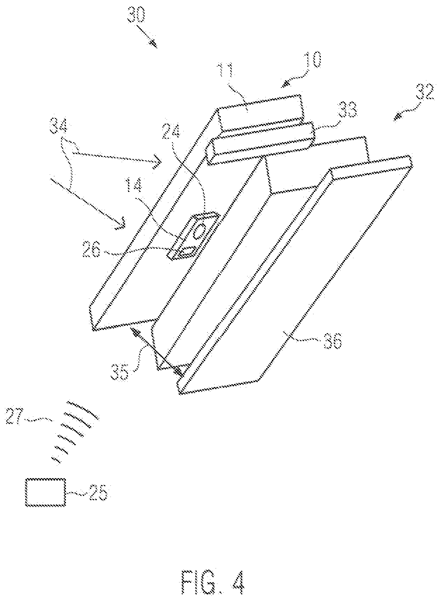

Fig. 4 zeigt einen Ausschnitt einer Gebäudestruktur 30, insbesondere einer Dachkonstruktion 32 als Anwendungsbeispiel für ein drittes Ausführungsbeispiel eines installierten erfindungsgemäßen Schichtaufbaus 10. Der Schichtaufbau 10 ist Teil der Dachkonstruktion und in diese integriert. Eine wärmeleitende Schicht 11 in Form eines Dachziegels wird über eine Querlattung 33 der Dachkonstruktion 32 gehalten. Es wird auf der Außenseite des Dachziegels Wärmestrahlung in Form von solarer Einstrahlung 34 bereitgestellt. Der Dachziegel wird von der Sonne angestrahlt und erwärmt sich dabei. Der Dachziegel kann dabei an der Oberfläche eine Temperatur von mehr als 100°C annehmen. Durch Wärmeleitung wird auf der der Sonne abgewandten Seite ebenfalls Wärme abgegeben. Ein Thermogenerator 14 wird in diesen Wärmestrom eingefügt. Auf diese Weise lässt sich elektrische Energie an diesem Thermogenerator 14 gewinnen. Dachkonstruktionen sind oft so aufgebaut, dass eine Hinterlüftung vorhanden ist. Diese Hinterlüftung dient zum einen dazu, Feuchtigkeit abzutransportieren, um eine Schimmelbildung an der Dachkonstruktion oder auch Feuchtigkeitsschäden an der vorhandenen Holzkonstruktion zu vermeiden. Zum anderen transportiert die Hinterlüftung Wärme aus dem Bereich ab, da sich das Dach ansonsten erheblich aufwärmt und somit die Wärmedämmung nicht mehr ausreichend funktioniert. Ein Abstand 35 zwischen Ziegel und Unterkonstruktion 36, z.B. einer Abspannung dient der Hinterlüftung. Der Abstand kann einige Millimeter aufweisen, beispielsweise in einem Bereich von etwa 10 mm bis etwa 100 mm. Vorteilhafterweise liegt der Abstand 35 im Zentimeterbereich, beispielsweise in einem Bereich von etwa 1 cm bis etwa 60 cm, oder vorzugsweise von etwa 5 cm bis etwa 35 cm, weiter vorzugsweise von etwa 10 cm bis etwa 20 cm, diese Werte sind abhängig von der Konstruktion.

In Fig. 4 trifft die solare Wärmestrahlung auf den die wärmeleitende Schicht 11 in Form eines Dachziegels, der die aufgenommene Wärme an den an ihr installierten Thermogenerator 14 weiterleitet. Der Thermogenerator 14 kann über eine Klebeschicht oder klebende Folienschicht oder ähnliches als wärmeleitende Kopplungsschicht 15 mit dem Dachziegel verbunden sein. Der Thermogenerator 14 ist in einem Abstand von der weiteren Unterkonstruktion 36 der Dachkonstruktion, beispielsweise von Abspannungen angeordnet, so dass eine Hinterlüftung zwischen Dachziegel und Abspannung stattfinden kann. Ferner kann an dem Thermogenerator 14 ein oder mehrere Sensoren 24 und eine Telekommunikationseinrichtung 26, in Fig. 4 eine Einrichtung mit einer drahtlosen Kommunikationsverbindung 27 angeschlossen werden, um Messwerte an einem anderen Ort mit einer Auswerteinheit 25 auswerten zu können.

Das Funktionsprinzip des Thermogenerators 14 basiert darauf, dass ein erwärmter Dachziegel eine gute Wärmeleitung und auch Wärmespeicherung hat und gleichzeitig die Hinterlüftung des Dachziegels für einen Temperaturdifferenz über dem Thermogenerator 14 sorgt. Zum Ausgleich von Unebenheiten des Dachziegels oder mehrerer Dachziegel kann zwischen dem Dachziegel bzw. den Dachziegeln und jeweils dem Thermogenerator 14 eine wärmeleitfähige Folie, insbesondere eine hochwärmeleitfähige, flexible Wärmeträgerfolie, eingebaut werden. Der Thermogenerator 14 ist dabei so auf dem Ziegel befestigt, dass dieser keinen thermischen Kurzschluss durch die Befestigung erfährt. Die Dachunterkonstruktion 36 gewährleistet eine entsprechende Luftzirkulation, ein Kamineffekt begünstigt die Luftzirkulation. Zur Erhöhung der Wärmeabgabe durch Konvektion kann der Thermogenerator 14 an seiner "kalten" Seite mit Kühlkörpern versehen sein, die vorzugsweise schwarze Farbe aufweisen bzw. schwarz lackiert sind.

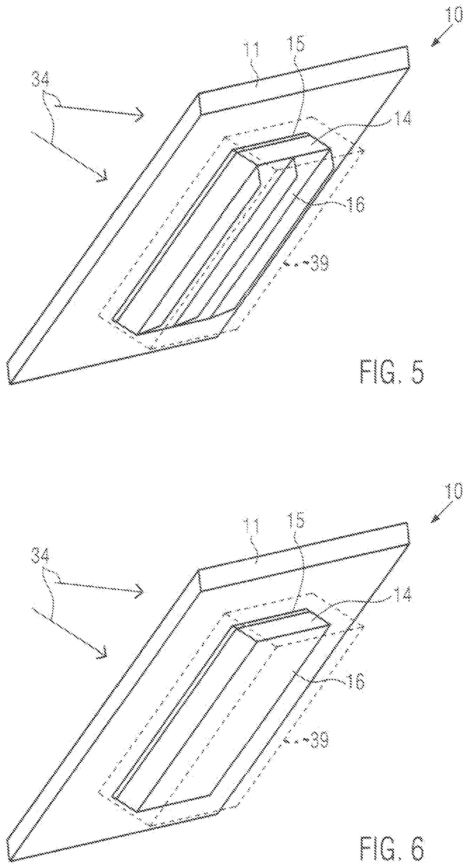

Fig. 5 zeigt eine Trägerstruktur mit einem vierten Ausführungsbeispiel eines installierten erfindungsgemäßen Schichtaufbaus. Hierbei ist der Thermogenerator, ähnlich wie in Fig. 3 an einer wärmeleitfähigen Schicht, z.B. einem Dachziegel befestigt.

Fig. 6 zeigt eine Trägerstruktur mit einem fünften Ausführungsbeispiel eines installierten erfindungsgemäßen Schichtaufbaus. Hierbei weist der Thermogenerator 14 keine Kühlkörper in Form von Kühlrippen auf. In dieser Ausführungsform in Fig. 6 weist der Thermogenerator 14 eine strukturaufweisende Oberfläche auf. Unter einer strukturaufweisenden Oberfläche kann eine Mikrostruktur oder eine Nanostruktur verstanden werden. Beispiele für eine strukturaufweisende Oberfläche können Strukturen sein, wie eine Haifischhaut, eine Fläche mit Lotuseffekt, eine Golfballoberfläche, eine Gitternetzstruktur, insbesondere eine ortsfeste Gitternetzstruktur oder ähnliche oberflächenvergrößernde Geometrien. Eine Mikrostruktur hat eine Rauheit im Mikrometerbereich und eine Nanostruktur hat eine Rauheit im Nanometerbereich. Es sind strukturaufweisende Oberflächen 26 jeglicher Geometrie und Rauheit möglich. Auch können wasserabweisende oder hydrophobe Strukturen als Oberflächen am Thermogenerator 14 von Vorteil sein. Allen vorgesehenen Strukturen gemeinsam ist die Vergrößerung der Oberfläche 26 des Thermogenerators 14. Eine vergrößerte Oberfläche 26 kann den Wirkungsgrad des Thermogenerators 14 infolge einer erhöhten Konvektion erhöhen. Auch kann die Oberfläche 26 durch eine aufgetragene Schicht an mindestens einer Seite des Thermogenerators 14 gebildet werden.

In Fig. 5 und in Fig. 6 ist der Thermogenerator 14 jeweils mit einer Umhüllung 39 umgeben. Diese Umhüllung kann unter anderem als Schutz des Thermogenerators vor elektromagnetischen Einflüssen am Installationsort verwendet werden. Ferner kann die Umhüllung 39 den Thermogenerator 14 und seine Beschaltung, z.B. Schutzschaltung, Wandlerelektronik und ähnliches vor Umwelteinflüssen, wie Feuchte, direkter solarer Strahlung oder Alterungserscheinungen schützen.

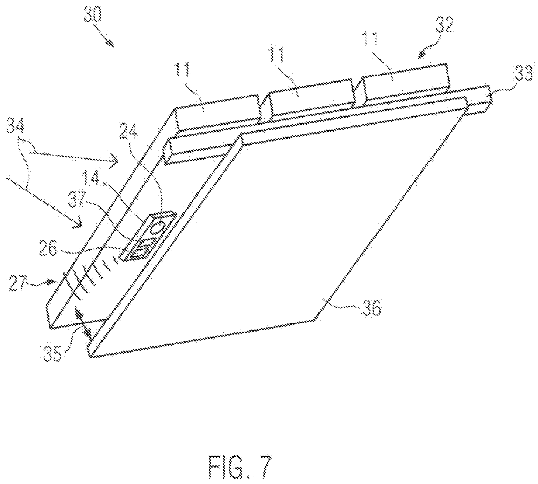

Fig. 7 zeigt einen Ausschnitt einer Gebäudestruktur, insbesondere einer Dachkonstruktion mit einem sechsten Ausführungsbeispiel eines installierten erfindungsgemäßen Schichtaufbaus. Bei diesem Ausführungsbeispiel sind die wärmeleitfähigen Schichten 11 als Dachziegel ausgebildet, die an einer Querlattung 33 befestigt sind. Zwischen den Ziegeln und einer Unterkonstruktion 36, hier eine Abdeckplatte der Dachkonstruktion, bildet sich ein Abstand 35. Durch den Abstand 35 bildet sich ein Hohlraum, in dem Luft zirkulieren kann. Diese Wärmekapazität der Luft bewirkt am Thermogenerator 14 eine elektrische Spannung, die von der Dachkonstruktion weggeführt wird und direkt nutzbar ist oder einem Energiespeicher zugeführt wird oder einer Wandlerelektronik z.B. Umrichter oder Spannungswandler zugeführt wird. Ferner kann vorgesehen werden, dass ein Energiespeicher am Schichtaufbau vorhanden ist. Es kann beispielsweise ein Energiespeicher am Thermogenerator vorhanden sein.

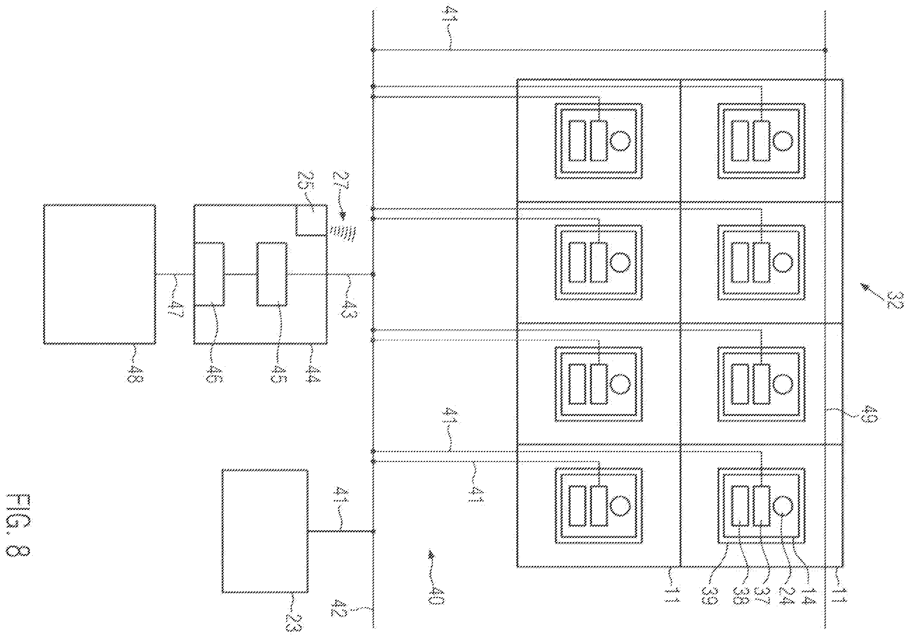

Fig. 8 zeigt schematisch ein Beispiel einer Zusammenschaltung einer Vielzahl von Thermogeneratoren 14 am Beispiel einer Gebäudestruktur, insbesondere einer Dachkonstruktion 32. Die Dachkonstruktion 32 weist eine Vielzahl von Elementen mit einer wärmeleitfähigen Schicht 11 auf, wobei die Elemente in Form von einzelnen Ziegel ausgebildet sind. Fig. 8 zeigt die Unterseite der Ziegel, wobei diese Unterseiten jeweils die einer solaren Einstrahlung abgewandt sind. Die Ziegel bilden insgesamt eine Dachabdeckung und können wie beispielsweise in Fig. 7 gezeigt, an einer Dachlattung 33 befestigt sein, beispielsweise durch ihre Formgebung an der Dachlattung 33 einhängbar sein. Die Dachlattung 33 kann beispielsweise ein über eine bestimmte Länge des Daches verlaufendes Kantholz sein.

Fig. 8 zeigt einzelne Ziegel, wobei an jedem Ziegel ein Thermogenerator 14 angeordnet ist. Es kann auch vorgesehen werden, dass nur eine bestimmte Anzahl an Ziegeln mit einem Thermogenerator 14 versehen ist. Ferner können die Thermogeneratoren 14 der Fig. 8 jeweils über eine Kopplungsschicht 15 oder über eine gemeinsame Kopplungsschicht 15 an der wärmeleitenden Schicht 11 befestigt sein, so dass möglichst die gesamte aufgenommene Wärme der wärmeleitenden Schicht 11 in die Thermogeneratoren 14 zur Erzeugung von elektrischer Energie verwendet werden kann. Auch können Wärmeleitgeometrien 17, wie beispielsweise in Fig. 2 dargestellt, in der Anordnung von Fig. 8 verwendet werden.

Ferner weisen die Thermogeneratoren 14 in Fig. 8 jeweils eine metallische Umhüllung 39 auf und sind von dieser partiell umgeben. Eine Teilumhüllung in Bezug auf den Thermogenerator ist vorteilhaft.. Eine metallische Umhüllung kann aus Aluminiummaterial oder Kupfermaterial gebildet sein. Die metallische Umhüllung 39 ist optional, sie ist vorteilhaft, da metallische Materialien elektromagnetische Felder abschirmen, jedoch Wärme und Kälte gut leiten, damit Temperaturschwankungen den Thermogenerator 14 erreichen. Die Thermogeneratoren 14 der Fig. 8 weisen jeweils einen Sensor 24 oder eine Vielzahl von Sensoren 24 auf. Die Thermogeneratoren 14 in Fig. 8 weisen auch mindestens eine Schutzvorrichtung auf, die als Schutzschaltung 38 ausgebildet ist. Diese schützt den Thermogenerator 14 vor direkten und indirekten Überspannungen, wie Blitzeinschlag und Induktion. Ferner weist jeder Thermogenerator 14 eine Einrichtung 37 zur Umwandlung einer Nutzspannung auf, die beispielsweise in Form eines Spannungswandlers und/oder A/D-Wandlers (Analog-Digital Wandler) ausgebildet ist. Die umgewandelte Nutzspannung wird über eine elektrische Verbindungen 41 einer Verbindungsanordnung 40 zugeleitet. Die elektrische Verbindung 41 verbindet jeden Thermogenerator 14 mit einer Sammelanordnung 42, beispielsweise einer Sammelschiene oder eines Kabels.

Ferner weist der Schichtaufbau in Fig. 8 einen faseroptischen Sensor 49 auf, der an der wärmeleitenden Schicht 11 angeordnet ist. Es kann auch vorgesehen werden, dass an einer Vielzahl von wärmeleitenden Schichten 11 eine Vielzahl von faseroptischen Sensoren 49 vorhanden sind. Mit einem faseroptischen Sensor 49 kann beispielsweise eine Dachziegelreihe in horizontaler oder vertikaler Richtung in Fig. 8 versehen werden. Bei einer Vielzahl von faseroptischen Sensoren 49 kann die Gebäudestruktur nachgebildet werden und beispielsweise eine Matrixstruktur oder Netzstruktur aus faseroptischen Sensoren 49 ausgebildet werden. Mit den faseroptischen Sensoren 49 ist es möglich, eine Temperaturverteilung an den wärmeleitenden Schichten oder einer wärmeleitenden Schicht als Gesamtfläche erfasst werden. Auch können ein oder mehrere faseroptische Sensoren 49 dazu verwendet werden, um Temperaturverteilungen in Bezug auf einen oder mehrere Thermogeneratoren zu messen. Die Messdaten der faseroptischen Sensoren 49 können in einer Auswerteeinrichtung verarbeitet werden und beispielsweise in einer bildlichen Darstellung mit Temperaturgradienten dargestellt werden, beispielsweise in Form einer bildlichen oder graphischen Darstellung mit Temperaturangaben. Für die Bereitstellung solcher Temperaturverteilungen ist in Fig. 8 vorgesehen, den einen exemplarisch dargestellten faseroptischen Sensor 49, der quer über die dargestellte Gebäudestruktur 30 verlegt ist, an die Auswertewertevorrichtung 44 anzukoppeln. Dies kann über die dargestellte Sammelanordnung 44 geschehen oder separat der Auswertewertevorrichtung 44 zugeführt werden.

Die schematisch gezeigte Sammelanordnung 42 in Fig. 8 kann eine Struktur über die gesamte Dachkonstruktion 32 ausbilden, um von jedem Thermogenerator 14 die Nutzspannung abzugreifen und nutzbar zu machen. An der Sammelanordnung 42 kann auch ein Energiespeicher 23 angeschlossen werden, um die erzeugte Energie der Thermogeneratoren 14 zu speichern. Auch kann alternativ zu einem Energiespeicher 23 an der Sammelanordnung 42 oder zusätzlich zu dem Energiespeicher 23 vorgesehen werden, dass die Thermogeneratoren 14 direkt mit einem Energiespeicher ausgestattet werden, der beispielsweise im Bereich des Thermogenerators 14 angeordnet ist. Es können somit Energiespeicher direkt am Thermogenerator angebracht sein. Weitere Möglichkeiten für Orte von Energiespeichern sind an der Sammelanordnung 44, wie z.B. an einer Sammelleitung oder nach einer vorhandenen Wandlerelektronik.

Die Sammelanordnung 42, wie auch die elektrischen Verbindungen 41, 43 können sowohl Nutzspannungen wie auch Messsignale führen. Die Nutzspannungen entstehen während der Energiegewinnung an den Thermogeneratoren 14. Die Messsignale können an den Sensoren 24 und den faseroptischen Sensoren 49 gewonnen werden. Hierbei kann vorteilhafterweise vorgesehen werden, dass Messsignale auf die Nutzspannungen aufmoduliert werden.

Alternative Möglichkeiten bestehen, indem separate Verbindungen von den jeweiligen Sensoren 24 bzw. 49 an die Auswertevorrichtung 44 oder eine weitere Auswertevorrichtung geführt werden. Die Auswertevorrichtung 44 kann auch eine Anzeige aufweisen, um Messergebnisse, Warnsignale oder weitere Informationen anzuzeigen. Ferner ist es auch möglich, die vorhanden elektrischen Verbindungen 41, 42, 43 durch andere Materialien oder Medien zu ersetzen, wie beispielsweise optische Verbindungen, wie Lichtwellenleiter oder drahtlose Verbindungen, z.B. zum Empfang von Signalen oder Messwerte über die drahtlose Kommunikationsverbindung 27 zwischen der wärmeleitenden Schicht 11 mit dort installierten Kommunikationsschnittstellen und der Auswertevorrichtung 44 oder weiteren Peripherie-Einrichtungen, wie mobilen Endgeräten, Cloud-Einrichtungen oder dem Internet

In Fig. 8 ist an der Sammelanordnung 42 eine elektrische Verbindung 43 vorhanden, um die Sammelanordnung 42 an eine Auswertevorrichtung 44 anzuschließen. Ferner werden Messsignale der Sensoren 24 ähnlich gesammelt, wie die Messdaten der Thermogeneratoren 14. Es können beispielsweise die Messsignale der Sensoren 24 über entsprechende Leitungen oder Funksignale geleitet werden und ebenso der Auswertevorrichtung 44 zugeführt werden. Die Auswertevorrichtung 44 weist eine Auswerteeinheit 25 aus, die die Sensorsignale beispielsweise über eine drahtlose Kommunikationsverbindung, wie beispielswiese WLAN, Bluetooth, Mobilfunk oder ähnliches empfangen kann. Auch kann die Auswerteeinheit 25 ein mobiles Endgerät sein, wie beispielsweise ein Smartphone oder Tablet-Gerät, das außerhalb der Auswertevorrichtung 44 angeordnet ist. Ferner weist die Auswertevorrichtung 44 einen Recheneinrichtung 45, beispielsweise zum Ausführen von Analysen der Messdaten. Es ist auch vorgesehen, dass die Auswertevorrichtung 44 eine Kommunikationsschnittstelle 46 aufweist, die über eine Kommunikationsverbindung 47 mit einer Peripherie-Einrichtung 48 verbunden ist. Diese Peripherie-Einrichtung 48 kann eine weitere Rechenanlage mit weiteren Analysemöglichkeiten sein. Diese Peripherie-Einrichtung 48 kann auch eine Datenbank sein, beispielsweise eine Cloud-basierte Datenbank, d.h. auf mehrere Orte verteilte Speicherkapazitäten. Auch kann die Peripherie-Einrichtung 48 das Internet und seine Infrastruktur darstellen, um an unterschiedlichen Orten Daten bereitzustellen.

Das schematisch gezeigte Ausführungsbeispiel in Fig. 8 kann auch eine Fasende eines Gebäudes darstellen, insbesondere eine Außenwand eines Gebäudes, bei der eine Gesamtfläche mit wärmeleitendem Material 11 installiert ist. Diese Gesamtfläche kann nur eine Element 11 aufweisen oder aus mehreren Elementen 11, wie in Fig. 8 gezeigt, gebildet werden, beispielsweise Fassadenverkleidungsplatten oder ähnliches. Ferner kann das gezeigte Ausführungsbeispiel in Fig. 8 auch einen Bereich oder einen Teil eines Transportmittels, beispielsweise ein Fahrzeug oder ein Bereich oder Teil eines Transportgutes betreffen, beispielsweise einen Container. Da die wärmeleitende Schicht als beliebige Geometrie ausgestaltet werden kann, beispielsweise auch gekrümmte Flächen, kann sie auch ein Fahrzeugdach oder einen anderen Bereich eines Fahrzeugs darstellen.

Zusammenfassend wird ein Schichtaufbau 10 mit mindestens einem Thermogenerator 14 zur Erzeugung von elektrischer Energie vorgeschlagen. Hierbei ist vorgesehen, dass über eine wärmeleitfähige Schicht 11 ein übertragener Wärmefluss dem Thermogenerator 14 oder den Thermogeneratoren 14 zugeführt wird. Der erfindungsgemäße Schichtaufbau 10 kann an unterschiedlichen Orten installiert werden, wie an einem Gebäude, einer Gebäudefassade, einer Dachkonstruktion oder einem Transportmittel. Insgesamt charakterisiert den Schichtaufbau 10 eine Schichtung mit einer Einstrahlfläche, auf die solare Einstrahlung treffen kann und mindestens einen Thermogenerator 14, der Temperaturdifferenzen an seinem Installationsort verwendet, um elektrische Energie zu erzeugen. Es ergibt sich ein Schichtaufbau mit einer wärmeleitfähigen Schicht und mindestens einem Thermogenerator zur Erzeugung von elektrischer Energie. Der Schichtaufbau 10 wurde anhand einer Gebäudekonstruktion, insbesondere einer Dachkonstruktion näher erläutert. Auch können andere Strukturen mit dem vorgeschlagenen Schichtaufbau versehen werden. Fahrzeuge sind hierbei ein Beispiel. Ferner können bereits installierte Strukturen nachgerüstet werden.

Insgesamt ergibt sich bei dem vorgeschlagenen Schichtaufbau und dessen Ausführungsformen eine Vielzahl von Vorteilen.

Der Schichtaufbau ist leicht in vorhandene Konstruktionen integrierbar. Ferner ist der Schichtaufbau beliebig in seiner Fläche skalierbar, d.h. beliebig große Flächen können mit dem Schichtaufbau gefertigt werden. Es können auch beliebig kleine Einheiten gefertigt werden, beispielsweise Dachziegel mit daran montiertem Thermogenerator über die Kopplungsschicht. Diese kleinen Einheiten können beliebig miteinander kombiniert werden. Hierbei können Thermogeneratoren elektrisch verschaltet werden, um Spannungen bzw. Ströme in beliebiger Höhe zu generieren.

Auch ist der Einbauort des Schichtaufbaus beliebig. Der Schichtaufbau kann so in eine Fläche integriert werden, dass der Thermogenerator und seine Beschaltung nicht sichtbar sind, da sie beispielsweise innenliegend installiert werden.

Da keine beweglichen Teile am Schichtaufbau vorhanden sind, lässt sich dieser in beliebiger Einbaulage, wie vertikal an Fassaden und Wänden, wie horizontal auf Flachdächern, wie schräg ausgerichtet auf Spitzdächern anordnen. Ferner ist die Geometrie des Schichtaufbaus beliebig anpassbar. So können gewölbte Formen, wie z.B. bei Fahrzeugdächern, Bahnwaggons oder ähnliches durch den Schichtaufbau gebildet werden. Durch eine geeignete Wahl des Materials der wärmeleitenden Schicht können auch hierbei unterschiedliche Materialien, die geeignet sind, Wärme zu leiten verwendet werden. Durch die kompakte Bauweise des Schichtaufbaus, d.h. Dicke nur wenige Millimeter oder Zentimeter, kann der erfindungsgemäße Schichtaufbau vielfältig in vorhandene Infrastruktur integriert werden. Ein Nachrüsten von Flächen ist ebenso möglich. Auch kann der vorgeschlagene Schichtaufbau mit Solarthermieanlagen kombiniert werden, da bereits Kollektoren zur Aufnahme von Wärmeenergie vorhanden sind. Auch ist es möglich, einzelne Abdeckelemente einer Gebäude- oder Dachkonstruktion mit Thermogeneratoren nachzurüsten. Dies ist besonders einfach, wenn die Abdeckelemente, wie Ziegel eines Daches einzeln austauchbar sind. Es kann auch nur eine Teilmenge der Ziegel ausgetauscht werden und somit mit Thermogeneratoren ausgestattet werden.

Bei dem zunehmenden Bedarf der Nutzung umweltschonender Energie kann die vorliegende Erfindung einen Beitrag liefern. Die solare Strahlung steht permanent zur Verfügung. Ebenso stehen umfangreiche Dachflächen zur Verfügung, die zur Energiegewinnung genutzt werden können. Neben der Nutzung der Dachflächen für Solarthermie oder Photovoltaik ist mit der vorliegenden Erfindung auch die direkte Produktion von elektrischer Energie durch Konvertierung von Wärmeenergie in elektrische Energie möglich. Damit kann z.B. der Autarkiegrad eines Gebäudes hinsichtlich der Energieversorgung gesteigert werden. Die Anwendung ist frei skalierbar, d.h. es können je nach Platzbedarf Thermogeneratoren parallel oder in Reihe geschaltet werden, um den Energieertrag zu erhöhen. Bedingt durch die Speicherfähigkeit von Dachziegeln (oder anderer Materialien) kann auch noch dann elektrische Energie erzeugt werden, sofern keine Sonnenstrahlung mehr vorhanden ist, z.B. nachts, jedoch noch gespeicherte thermische Energie im Material vorhanden ist. Auch weitere Gebäudeflächen oder Flächen an Transportmittel können genutzt werden, um Thermogeneratoren in dem aufgezeigten Schichtaufbau zu installieren.

Durch die Verwendung des vorgeschlagenen Schichtaufbaus entstehen keine Folgekosten, da eine einmalige Installation ohne weitere Pumpen oder Aggregate notwendig ist. Durch das Prinzip der Nutzung eines Wärmeflusses bzw. einer Temperaturdifferenz können sowohl Aufwärmphasen als auch Abkühlphasen zur Erzeugung von elektrischer Energie genutzt werden. Die elektrische Energiegewinnung ist daher unabhängig von einer Richtung eines Temperaturgradienten. Auf diese Weise kann elektrische Energie erzeugt werden unabhängig von der solaren Einstrahlung.

### Bezugszeichenliste

- 10: Schichtaufbau
- 11: wärmeleitfähige Schicht
- 12: erste Seite der wärmeleitfähigen Schicht
- 13: zweite Seite der wärmeleitfähigen Schicht
- 14: Thermogenerator
- 15: Kopplungsschicht
- 16: strukturaufweisende Oberfläche
- 17: Wärmeleitgeometrie
- 18: Bereich mit weniger hohem Wärmeleitwert
- 19: Bereich mit hohem Wärmeleitwert
- 20: elektrische Energie
- 21: erster Wärmefluss
- 22: zweiter Wärmefluss
- 23: Energiespeicher
- 24: Sensor
- 25: Auswerteeinheit
- 26: Telekommunikationseinrichtung
- 27: drahtlose Kommunikationsverbindung
- 28: flächiger Wärmefluss
- 29: flächiger Wärmefluss
- 30: Gebäudestruktur
- 31: Pfeil
- 32: Dachkonstruktion
- 33: Querlattung
- 34: solare Einstrahlung
- 35: Abstand
- 36: Unterkonstruktion
- 37: Nutzspannungsumwandlungseinrichtung, z.B. Spannungswandler, A/D-Wandler,
- 38: Schutzschaltung
- 39: Umhüllung, z.B. EMV-dichte Kapselung
- 40: Verbindungsanordnung
- 41: elektrische Verbindung
- 42: Sammelanordnung
- 43: elektrische Verbindung
- 44: Auswertevorrichtung
- 45: Recheneinrichtung
- 46: Kommunikationsschnittstelle
- 47: Kommunikationsverbindung
- 48: Peripherie-Einrichtung
- 49: faseroptischer Sensor

## Patentansprüche

1. Schichtaufbau (10) zur Erzeugung von elektrischer Energie (20) aufweisend
eine wärmeleitfähige Schicht (11), einen Thermogenerator (14) und eine Schutzvorrichtung,
wobei
die wärmeleitfähige Schicht (11) eine erste Seite (12) und eine zweite Seite (13) aufweist, wobei durch die wärmeleitfähige Schicht (11) hindurch ein Wärmefluss (21, 22) übertragbar ist, wobei der übertragene Wärmefluss (21, 22) dem Thermogenerator (14) zuführbar ist, mit dem elektrische Energie (20) erzeugbar ist,
wobei zwischen der ersten Seite (12) der wärmeleitfähigen Schicht (11) und dem Thermogenerator (14) eine Kopplungsschicht (15) angeordnet ist, **dadurch gekennzeichnet, daß** die Schutzvorrichtung eine Schutzschaltung (38) zum Schutz vor Überspannungen ist.

2. Schichtaufbau (10) nach Anspruch 1, wobei der Schichtaufbau (10) mindestens eine strukturaufweisende Oberfläche (16) aufweist.

3. Schichtaufbau (10) nach Anspruch 1 oder Anspruch 2, wobei der Schichtaufbau (10) eine Wärmeleitgeometrie (17) aufweist.

4. Schichtaufbau (10) nach mindestens einem der vorhergehenden Ansprüche, wobei
der Thermogenerator (14) in zwei Richtungen des Wärmeflusses (21, 22) betreibbar ist.

5. Schichtaufbau (10) nach mindestens einem der vorhergehenden Ansprüche, wobei
eine Vielzahl von Thermogeneratoren (14) elektrisch verbunden ist.

6. Schichtaufbau (10) nach mindestens einem der vorhergehenden Ansprüche, wobei
der Schichtaufbau (10) mindestens eine Telekommunikationseinrichtung (26) aufweist.

7. Schichtaufbau (10) nach mindestens einem der vorhergehenden Ansprüche, wobei
die Schutzvorrichtung als Umhüllung (39) ausgebildet ist, insbesondere als eine elektromagnetisch-abgedichtete Kapselung.

8. Schichtaufbau (10) nach mindestens einem der vorhergehenden Ansprüche , wobei die Schutzvorrichtung einen oder eine Vielzahl von Sensoren (24) aufweist.

9. Schichtaufbau (10) nach mindestens einem der vorhergehenden Ansprüche, wobei
der Schichtaufbau (10) eine Wärmetransport-hindernde Schicht aufweist.

10. Schichtaufbau (10) nach mindestens einem der vorhergehenden Ansprüche, wobei
der Schichtaufbau (10) einen faseroptischen Sensor (49) oder eine Vielzahl von faseroptischer Sensoren (49) aufweist.

11. Verfahren zur Erzeugung von elektrischer Energie (20) mit einem Schichtaufbau (10) aufweisend
Bereitstellen einer wärmeleitfähigen Schicht (11) mit einer ersten Seite (12) und einer zweiten Seite (13), wobei durch die wärmeleitfähige Schicht (11) hindurch ein Wärmefluss (21, 22) übertragbar ist;
Bereitstellen eines Thermogenerators (14);
Anordnen einer Kopplungsschicht (15) zwischen der ersten Seite (12) der wärmeleitfähigen Schicht (11) und dem Thermogenerator (14);
Zuführen des übertragenen Wärmeflusses (21, 22) an den Thermogenerator (14);
Erzeugen von elektrischer Energie (20) mit dem Thermogenerator (14); und
Bereitstellen einer Schutzvorrichtung, wobei die Schutzvorrichtung eine Schutzschaltung (38) zum Schutz vor Überspannungen ist.

12. Gebäudestruktur (30) aufweisend einen Schichtaufbau (10) nach mindestens einem der Ansprüche 1 bis 10.

13. Gebäudestruktur (30) nach Anspruch 12, wobei die Gebäudestruktur (30) eine Vielzahl von Thermogeneratoren (14) aufweist, die über eine Sammelanordnung (42) miteinander verbunden ist.

14. Gebäudestruktur (30) nach Anspruch 12 oder Anspruch 13, wobei die Gebäudestruktur (30) eine erste Seite aufweist, die einer solaren Einstrahlung (34) zugewandt ist und eine zweite Seite aufweist, die der solaren Einstrahlung (34) abgewandt ist, wobei auf der ersten Seite ein Solarmodul angeordnet ist und wobei der Thermogenerator (14) oder die Vielzahl von Thermogeneratoren (14) auf der zweiten Seite angeordnet ist.

15. Energieerzeugungsanlage aufweisend einen Schichtaufbau (10) nach mindestens einem der Ansprüche 1 bis 10.

## Claims

1. Layer construction (10) for generating electrical energy (20), comprising
a thermally conductive layer (11), a thermo generator (14) and a protective apparatus,
wherein the thermally conductive layer (11) comprises a first side (12) and a second side (13), wherein a heat flow (21, 22) is transferable through the thermally conductive layer (11), wherein the transferred heat flow (21, 22) is suppliable to the thermo generator (14) with which electrical energy (20) can be generated,
wherein a coupling layer (15) is arranged between the first side (12) of the thermally conductive layer (11) and the thermogenerator (14), **characterized in that**, the protective apparatus is a protective circuit (38) for protection against overvoltages.

2. Layer construction (10) according to claim 1, wherein the layer construction (10) comprises at least one structured surface (16).

3. Layer construction (10) according to claim 1 or claim 2, wherein the layer construction (10) comprises a heat conducting geometry (17).

4. Layer construction (10) according to at least one of the preceding claims, wherein the thermogenerator (14) is operable in two directions of the heat flow (21, 22).

5. Layer construction (10) according to at least one of the preceding claims, wherein a plurality of thermogenerators (14) is electrically connected.

6. Layer construction (10) according to at least one of the preceding claims, wherein the layer construction (10) comprises at least one telecommunication device (26).

7. Layer construction (10) according to at least one of the preceding claims, wherein the protective apparatus is formed as an encasement (39), in particular, as an electromagnetically sealed encapsulation.

8. Layer construction (10) according to at least one of the preceding claims, wherein the protective apparatus comprises one or a plurality of sensors (24).

9. Layer construction (10) according to at least one of the preceding claims, wherein the layer construction (10) comprises a heat transport-preventing layer.

10. Layer construction (10) according to at least one of the preceding claims, wherein the layer construction (10) comprises a fiber optic sensor (49) or a plurality of fiber optic sensors (49).

11. Method for generating electrical energy (20) with a layer construction (10) comprising
providing a thermally conductive layer (11) having a first side (12) and a second side (13), wherein a heat flow (21, 22) is transferable through the thermally conductive layer (11);
providing a thermogenerator (14);
arranging a coupling layer (15) between the first side (12) of the thermally conductive layer (11) and the thermogenerator (14);
supplying the transferred heat flow (21, 22) to the thermogenerator (14);
generating electrical energy (20) with the thermogenerator (14); and
providing a protective apparatus, wherein the protective apparatus is a protective circuit (38) for protection against overvoltages.

12. Building structure (30) comprising a layer construction (10) according to at least one of claims 1 to 10.

13. Building structure (30) according to claim 12, wherein the building structure (30) comprises a plurality of thermo generators (14) which are connected together via a collective arrangement (42).

14. Building structure (30) according to claim 12 or claim 13, wherein the building structure (30) comprises a first side facing a solar radiation (34) and comprising a second side facing away from the solar radiation (34), wherein a solar module is arranged on the first side and wherein the thermogenerator (14) or the plurality of thermogenerators (14) is arranged on the second side.

15. Energy generation system comprising a layer construction (10) according to at least one of claims 1 to 10.

## Revendications

1. Construction stratifiée (10) pour la production d'énergie électrique (20), présentant
une couche thermoconductrice (11), un générateur thermique (14) et un dispositif de protection, dans laquelle
la couche thermoconductrice (11) présente un premier côté (12) et un second côté (13), dans laquelle un flux de chaleur (21, 22) peut être transmis à travers la couche thermoconductrice (11), dans laquelle le flux de chaleur (21, 22) transmis peut être amené au thermogénérateur (14), avec lequel de l'énergie électrique (20) peut être produite,
dans laquelle une couche de couplage (15) est disposée entre le premier côté (12) de la couche thermoconductrice (11) et le générateur thermique (14), **caractérisée en ce que** le dispositif de protection est un circuit de protection (38) pour la protection contre les surtensions.

2. Construction stratifiée (10) selon la revendication 1, dans laquelle la construction stratifiée (10) présente au moins une surface (16) présentant une structure.

3. Construction stratifiée (10) selon la revendication 1 ou la revendication 2, dans laquelle la construction stratifiée (10) présente une géométrie de conduction thermique (17).

4. Construction stratifiée (10) selon l'une au moins des revendications précédentes, dans laquelle le thermogénérateur (14) peut fonctionner dans deux directions du flux de chaleur (21, 22).

5. Construction stratifiée (10) selon l'une au moins des revendications précédentes, dans laquelle une pluralité de générateurs thermiques (14) sont reliés électriquement.

6. Construction stratifiée (10) selon l'une au moins des revendications précédentes, dans laquelle la construction stratifiée (10) présente au moins un système de télécommunication (26).

7. Construction stratifiée (10) selon l'une au moins des revendications précédentes, dans laquelle le dispositif de protection est réalisé en tant qu'enveloppe (39), en particulier en tant qu'une encapsulation étanche électromagnétiquement.

8. Construction stratifiée (10) selon l'une au moins des revendications précédentes, dans laquelle le dispositif de protection présente un ou une pluralité de capteurs (24).

9. Construction stratifiée (10) selon l'une au moins des revendications précédentes, dans laquelle la construction stratifiée (10) présente une couche empêchant le transport de chaleur.

10. Construction stratifiée (10) selon l'une au moins des revendications précédentes, dans laquelle la construction stratifiée (10) présente un capteur à fibre optique (49) ou une pluralité de capteurs à fibre optique (49).

11. Procédé de production d'énergie électrique (20) avec une construction stratifiée (10) présentant
fournir une couche thermoconductrice (11) comprenant un premier côté (12) et un second côté (13), dans lequel un flux de chaleur (21, 22) peut être transmis à travers la couche thermoconductrice (11) ;
fournir un générateur thermique (14) ;
disposer une couche de couplage (15) entre le premier côté (12) de la couche thermoconductrice (11) et le thermogénérateur (14) ;
amener le flux de chaleur (21, 22) transmis au générateur thermique (14) ;
produire de l'énergie électrique (20) avec le générateur thermique (14) ; et
fournir un dispositif de protection, dans lequel le dispositif de protection est un circuit de protection (38) pour la protection contre les surtensions.

12. Structure de bâtiment (30) présentant une construction stratifiée (10) selon l'une au moins des revendications 1 à 10.

13. Structure de bâtiment (30) selon la revendication 12, dans laquelle la structure de bâtiment (30) présente une pluralité de thermogénérateurs (14) qui sont reliés entre eux par un ensemble collecteur (42).

14. Structure de bâtiment (30) selon la revendication 12 ou la revendication 13, dans laquelle la structure de bâtiment (30) présente un premier côté qui est tourné vers un rayonnement solaire (34) et présente un second côté qui est à l'opposé du rayonnement solaire (34), dans laquelle un module solaire est disposé sur le premier côté et dans laquelle le thermogénérateur (14) ou la pluralité de thermogénérateurs (14) est disposé sur le second côté.

15. Installation de production d'énergie présentant une construction stratifiée (10) selon l'une au moins des revendications 1 à 10.
